Europäisches Patentamt

European Patent Office

Office européen des brevets

(11) Publication number: **0 414 546 A2**

# EUROPEAN PATENT APPLICATION

(21) Application number: **90309266.6**

(51) Int. Cl.5: **G06F 13/40**

(22) Date of filing: **23.08.90**

(30) Priority: **23.08.89 US 397706**

(43) Date of publication of application:
**27.02.91 Bulletin 91/09**

(84) Designated Contracting States:
**DE FR GB**

(71) Applicant: **NCR CORPORATION**
**World Headquarters**
**Dayton, Ohio 45479(US)**

(72) Inventor: **Alexander, Arthur Ray**
**29411 Stargaze Lane**
**Valley Center, California 92682(US)**
Inventor: **Rostek, Paul Michael**
**11480 Cabela Place**
**San Diego, California 92127(US)**

(74) Representative: **Robinson, Robert George**
**International Patent Department NCR Limited**
**915 High Road North Finchley**
**London N12 8QJ(GB)**

(54) Backpanel having multiple logic family signal layers.

(57) A printed circuit board backpanel (100) uses strip-line construction to allow emitter coupled logic (ECL) signals and transistor-transistor logic (TTL) signals on the same signal layer, while providing electromagnetic interference (EMI) emission control. Disposed between ground layers (102,130), and separated by dielectric layers (104, 108, 112, 116, 120, 124, 128), are arranged signal layers (106, 114, 118, 126) and power layers (110, 122).

## BACKPANEL HAVING MULTIPLE LOGIC FAMILY SIGNAL LAYERS

The present invention relates to backpanels, such as are used in computer systems for carrying power supply and signal lines.

Backpanels may need to carry busses for more than one logic family, when those logic families are present in the computer system served. For example, a computer system may contain emitter-coupled logic (ECL circuits and transistor-transistor logic (TTL) circuits which require separate busses. ECL busses require approximately 50 ohms nominal impedance.

It is an object of the present invention to provide a new and improved backpanel.

Therefore, according to one aspect of the present invention, there is provided a backpanel, characterized by at least one signal layer comprising a plurality of busses separately dedicated to each of plurality of logic families, each said bus exclusively carrying signals corresponding to a particular logic family.

According-to another aspect of the invention, there is provided a multi-layered backpanel, characterized by at least one signal layer adapted to carry signals representing a plurality of logic families, at least one power layer adapted to carry supply power; wherein inside layers of said backpanel alternate between signal layers and power layers, with dielectric layers disposed between said signal and power layers, and dielectric layers disposed adjacent said ground layers.

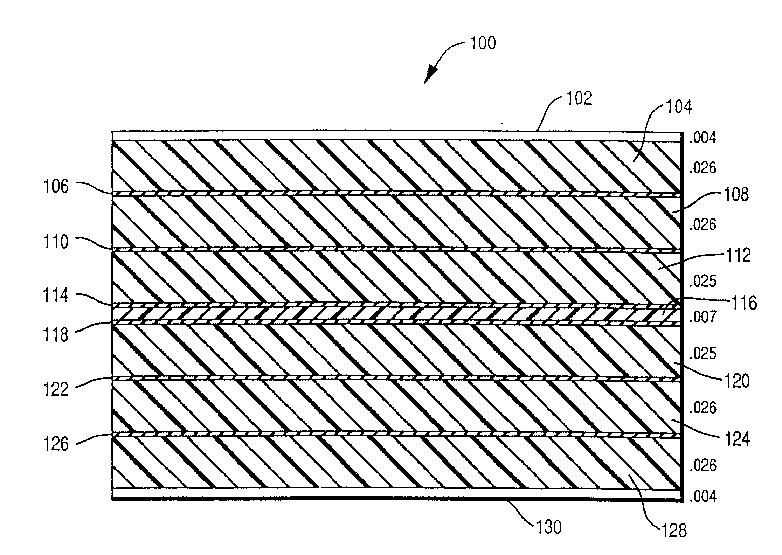

One embodiment of the present invention will now be described by way of example, with reference to the accompanying drawing, in which the sole Figure is a cross-sectional side view of a backpanel according to the invention.

Referring now to the drawing figure, a dual sided backpanel 100 surrounded by ground layers 102 and 130 has a number of dielectric substrate layers 104, 108, 112, 116, 120, 124 and 128 positioned between several signal layers 106, 114, 118 and 126 and two power layers 110 and 122. The thicknesses (in inches) of the various substrate and ground layers are indicated immediately to the right of the layers in the drawing figure. The thicknesses of 0.004 inches, 0.007 inches, 0.025 inches and 0.026 inches, are approximately, 0.10 millimetres, 0.18 millimetres, 0.64 millimetres and 0.66 millimeters, respectively.

The signal and power layers of the backpanel 100 are constructed either by bonding copper (periodic symbol Cu) film to the substrates and etching away appropriate areas to leave the desired patterns, or by depositing the appropriate pattern of copper onto the substrates. In the preferred embodiment all signal layers --including the layer 118, which also carries 12 volt power and minus 12 volt power--are constructed of copper material with a distribution of 1 ounce (28 grams) of copper per square foot (0.09 square metre). The ground layers 102 and 130, as well as the 5 volt power layers 110 and 122 have a distribution of 2 ounces (57 grams) of copper per square foot (0.09 square metre).

TTL busses typically have trace widths of 10-11mil (254-280 micrometres) while ECL busses typically have trace widths of 25-27 mil (635-685 micrometres). The configuration of the backpanel 100 allows the number of signal layers to be limited to the number necessary to carry the TTL busses, and allows the optimum impedance characteristics for each logic family to obtain high signal integrity and low signal distortion. An added benefit of the configuration, and more particularly the surrounding of the signal layers by the power and ground la\ers, is a reduction in the amount of EMI emissions form the backpanel 100.

The described construction results in a low effective dielectric value (and low impedance) for the signal layers, thereby allowing for smaller bus trace widths. Hence both ECL and TTL signals can be transmitted on the same signal layer.

## Claims

1. A backpanel, characterized by at least one signal layer (106, 114, 118, 126) comprising a plurality of busses separately dedicated to each of a plurality of logic families, each said bus exclusively carrying signals corresponding to a particular logic family.

2. A backpanel according to claim 1, characterized in that the number of said logic families is two, and the two logic families are of the ECL and TTL type.

3. A backpanel according to claim 1 or claim 2, characterized by ground layers (102, 130) forming the outer boundary layers of said backpanel.

4. A backpanel according to claim 4 characterized by at least one power layer (110, 122) wherein each signal layer (106, 114, 118, 126) is disposed between a ground layer (102, 130) and a power layer (110, 122).

5. A multi-layered backpanel, characterized by at least one signal layer (106, 114, 118, 126) adapted to carry signals representing a plurality of logic families at least one power layer (110, 122) adapted to carry supply power; at least one dielectric layer (104, 108, 112, 116, 120, 124, 128); and two ground layers (102, 130) forming outer layers of said backpanel; wherein inside layers of said backpanel alternate between signal layers (106, 114, 118, 126) and power layers (110, 122) with dielectric layers (108, 112, 120, 124) disposed between said signal (106, 114, 118, 126) and power (110, 122) layers, and dielectric layers (104, 128) disposed adjacent said ground layers (102,130).

6. A backpanel according to claim 5, characterized in that the number of said logic families is two.

7. A backpanel according to claim 5 or claim 6 characterized in that the dielectric layers (104,128) disposed adjacent said ground layers (102, 130) are also disposed adjacent signal layers (106, 126).

100

102    104
.004
.026
106                                                108
.026
110                                                112
.025
114                                                116
.007
118                                                120
.025
122                                                124
.026
126
.026
.004
130                                                128

EP 0 414 546 A2